(19) **Europäisches Patentamt / European Patent Office / Office européen des brevets**

(11) **EP 4 350 435 B1**

(12) **EUROPEAN PATENT SPECIFICATION**

(45) Date of publication and mention
of the grant of the patent:
**17.06.2026   Bulletin 2026/25**

(21) Application number: **22816203.8**

(22) Date of filing: **02.06.2022**

(51) International Patent Classification (IPC):
**G03F 1/24** $^{(2012.01)}$      **G03F 1/54** $^{(2012.01)}$

(52) Cooperative Patent Classification (CPC):
**G03F 1/54; G03F 1/24**

(86) International application number:
**PCT/JP2022/022524**

(87) International publication number:
**WO 2022/255458 (08.12.2022 Gazette 2022/49)**

(54) **REFLECTIVE PHOTOMASK BLANK AND REFLECTIVE PHOTOMASK**

REFLEKTIERENDER FOTOMASKENROHLING UND REFLEKTIERENDE FOTOMASKE

ÉBAUCHE DE MASQUE PHOTOGRAPHIQUE RÉFLÉCHISSANT ET MASQUE PHOTOGRAPHIQUE RÉFLÉCHISSANT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority:   **02.06.2021   JP 2021092981**

(43) Date of publication of application:
**10.04.2024   Bulletin 2024/15**

(60) Divisional application:
**26176152.2 / 4 760 389**

(73) Proprietor: **Tekscend Photomask Corp.**
**Tokyo 105-7133 (JP)**

(72) Inventors:
• **YAMAGATA, Yuto**
**Tokyo 110-0016 (JP)**

• **GODA, Ayumi**
**Tokyo 110-0016 (JP)**
• **NAKANO, Hideaki**
**Tokyo 110-0016 (JP)**
• **ICHIKAWA, Kenjiro**
**Tokyo 110-0016 (JP)**
• **MIYAWAKI, Daisuke**
**Tokyo 110-0016 (JP)**

(74) Representative: **Hoffmann Eitle**
**Patent- und Rechtsanwälte PartmbB**
**Arabellastraße 30**
**81925 München (DE)**

(56) References cited:
**WO-A1-2019/009211      WO-A1-2020/100632
WO-A1-2020/100632      WO-A1-2020/137928
WO-A1-2020/241780      WO-A1-2021/161792
WO-A1-2021/161792      JP-A- 2010 103 463
JP-A- 2013 532 381      JP-A- 2019 139 085**

**Description**

Technical Field

The present invention relates to a reflective photomask used in lithography using a light in the ultraviolet region as a light source and a reflective photomask blank for producing the same.

Background Art

In a manufacturing process of semiconductor devices, a demand for miniaturization by a photolithography technology has increased with the miniaturization of the semiconductor devices. The minimum resolution dimension of a transfer pattern in the photolithography largely depends on the wavelength of an exposure light source, and the minimum resolution dimension can be made smaller as the wavelength is shorter. Therefore, as the exposure light source, a conventional ArF excimer laser light having a wavelength of 193 nm has been replaced with a light in the EUV (Extreme Ultra Violet) region having a wavelength of 13.5 nm.

The light in the EUV region is absorbed by most materials at a high ratio, and therefore a reflective photomask is used as a photomask for EUV exposure (EUV mask) (see PTL 1, for example). PTL 1 discloses an EUV photomask obtained by forming a reflective layer containing a multi-layer film in which molybdenum (Mo) layers and silicon (Si) layers are alternately deposited on a glass substrate, forming an absorption layer containing tantalum (Ta) as the main ingredient on the reflective layer, and forming a pattern on the absorption layer.

Further, in the EUV lithography, a dioptric system utilizing light transmission cannot be used as described above, and therefore an optical system member of an exposure machine is not a lens but a reflective type (mirror). This poses a problem that an incident light and a reflected light on a reflective photomask (EUV mask) cannot be coaxially designed. Thus, in the EUV lithography, a technique is commonly employed which includes making the EUV light incident by tilting the optical axis by 6° from the vertical direction of the EUV mask and guiding a reflected light reflected at an angle of -6° to a semiconductor substrate.

As described above, the optical axis is tilted through the mirror in the EUV lithography, and therefore it is known that a problem referred to as a so-called "shadowing effect" occurs in which the EUV light incident on the EUV mask creates a shadow of a mask pattern (patterned absorption layer) of the EUV mask arises.

In a current EUV mask blank, a film containing tantalum (Ta) as the main ingredient having a film thickness of 60 nm to 90 nm is used as the absorption layer. When the exposure of the pattern transfer is performed with an EUV mask produced using the mask blank, there is a risk of causing a reduction in the contrast in an edge portion to be shadowed by the mask pattern, depending on the relationship between the incident direction of the EUV light and the orientation of the mask pattern. Consequently, problems, such as an increase in line edge roughness of the transfer pattern on the semiconductor substrate and an inability to form a line width with a target dimension, occur, thereby deteriorating the transfer performance in some cases.

Thus, a reflective photomask blank in which a material forming the absorption layer is changed from tantalum (Ta) to a material having high absorptivity (extinction coefficient) to the EUV light and a reflective photomask blank in which a material having high absorptivity to the EUV light is added to tantalum (Ta) have been studied. For example, PTL 2 describes a reflective photomask blank in which the absorption layer is formed of a material containing 50 at% or more of Ta as the main ingredient and further containing at least one element selected from tellurium (Te), antimony (Sb), platinum (Pt), iodine (I), bismuth (Bi), iridium (Ir), osmium (Os), tungsten (W), rhenium (Re), tin (Sn), indium (In), polonium (Po), iron (Fe), gold (Au), mercury (Hg), gallium (Ga), and aluminum (Al).

Further, the mirror is known to be contaminated with by-products (e.g., tin (Sn)), carbon (C), or the like caused by the generation of the EUV. The accumulation of contaminants on the mirror reduces the reflectance of the mirror surface and reduces the throughput of a lithographic apparatus in some cases. To address this problem, PTL 3 discloses a method for removing the contaminants from the mirror by generating hydrogen radicals in the apparatus and reacting the contaminants with the hydrogen radicals.

However, in the reflective photomask blank described in PTL 2, resistance to hydrogen radicals is not described. Therefore, a transfer pattern (mask pattern) formed on the absorption layer by the introduction to the EUV exposure apparatus cannot be stably maintained, and as a result, there is a possibility that the transferability deteriorates.

A further reflective photomask blank forming part of the prior art is disclosed in WO 2020/137928 A1.

Citation List

Patent Literatures

PTL 1: JP 2011-176162 A
PTL 2: JP 2007-273678 A
PTL 3: JP 2011-530823 A

## Summary of Invention

Technical Problem

Thus, it is an object of the present invention to provide a reflective photomask blank and a reflective photomask suppressing or reducing the shadowing effect of a reflective photomask for patterning transfer using a light having a wavelength in the extreme ultraviolet region as a light source and having hydrogen radical resistance. More specifically, it is an object of the present invention to provide a reflective photomask in which a possibility that the transferability deteriorates is reduced by imparting the hydrogen radical resistance to a light absorption layer, and a reflective photomask blank for producing the same.

Solution to Problem

To solve the above-described problems, a reflective photomask blank according to one embodiment of the present invention is a reflective photomask blank for producing a reflective photomask for pattern transfer using an extreme ultraviolet light as a light source, and includes: a substrate; a reflective part formed on the substrate and configured to reflect an incident light; and a low reflective part formed on the reflective part and configured to absorb an incident light, in which the reflective part includes a multi-layer reflective film and a capping layer, the low reflective part contains a high extinction coefficient material which is a material having an extinction coefficient to an EUV light larger than 0.041, tantalum (Ta), and at least one of a material group consisting of titanium (Ti), niobium (Nb), tungsten (W), and molybdenum (Mo) and contains the high extinction coefficient material in a proportion larger than 50 at%, the content ratio of the at least one of the material group consisting of the titanium (Ti), the niobium (Nb), the tungsten (W), and the molybdenum (Mo) in the low reflective part is equal to or less than the content ratio of the tantalum (Ta), the total film thickness of the low reflective part is 45 nm or less, and the OD (Optical Density) value of the low reflective part is 1.0 or more.

To solve the above-described problems, a reflective photomask according to one embodiment of the present invention is a reflective photomask for pattern transfer using an extreme ultraviolet light as a light source, and includes: a substrate; a reflective part formed on the substrate and configured to reflect an incident light; and a low reflective part formed on the reflective part and configured to absorb an incident light, in which the reflective part includes a multi-layer reflective film and a capping layer, the low reflective part contains a high extinction coefficient material which is a material having an extinction coefficient to an EUV light larger than 0.041, tantalum (Ta), and at least one of a material group consisting of titanium (Ti), niobium (Nb), tungsten (W), and molybdenum (Mo) and contains the high extinction coefficient material in a proportion larger than 50 at%, the content ratio of the at least one of the material group consisting of the titanium (Ti), the niobium (Nb), the tungsten (W), and the molybdenum (Mo) in the low reflective part is equal to or less than the content ratio of the tantalum (Ta), the total film thickness of the low reflective part is 45 nm or less, and the OD (Optical Density) value of the low reflective part is 1.0 or more.

Advantageous Effects of Invention

According to one aspect of the present invention, transfer performance to a semiconductor substrate is improved in patterning using the light having a wavelength in the extreme ultraviolet region as a light source, and resistance to the external environment can be expected when the photomask is manufactured and used. More specifically, the reflective photomask blank and the reflective photomask according to one embodiment of the present invention suppress or reduce the shadowing effect of the reflective photomask for patterning transfer using the light having a wavelength in the extreme ultraviolet region as a light source and have the hydrogen radical resistance.

Brief Description of Drawings

FIG. 1 is a schematic cross-sectional view illustrating the structure of a reflective photomask blank according to an embodiment of the present invention;
FIG. 2 is a schematic cross-sectional view illustrating the structure of a reflective photomask according to an embodiment of the present invention;

FIG. 3 is a map illustrating a refractive index n and an extinction coefficient k at the wavelength of an EUV light;

FIG. 4 is a schematic cross-sectional view illustrating the structure of a reflective photomask according to a modification of the embodiment of the present invention;

FIG. 5 is a schematic cross-sectional view illustrating the structure of a reflective photomask blank according to Examples of the present invention;

FIG. 6 is a schematic cross-sectional view illustrating a manufacturing process of the reflective photomask according to Examples of the present invention;

FIG. 7 is a schematic cross-sectional view illustrating a manufacturing process of the reflective photomask according to Examples of the present invention;

FIG. 8 is a schematic cross-sectional view illustrating a manufacturing process of the reflective photomask according to Examples of the present invention;

FIG. 9 is a schematic cross-sectional view illustrating a manufacturing process of the reflective photomask according to Examples of the present invention;

Fig. 10 is a schematic plan view illustrating the shape of a design pattern of the reflective photomask according to Examples of the present invention;

FIG. 11 is a schematic cross-sectional view illustrating the structure of a reflective photomask blank according to Comparative Example of the present invention; and

Fig. 12 is a schematic cross-sectional view illustrating the structure of a reflective photomask according to Comparative Example of the present invention.

Description of Embodiments

Hereinafter, embodiments of the present invention are described with reference to the drawings, but the present invention is not limited to the following embodiments. In the embodiments described below, a technically preferable limitation is made to implement the present invention, but this limitation is not a requirement of the present invention. The invention is instead defined by the appended claims.

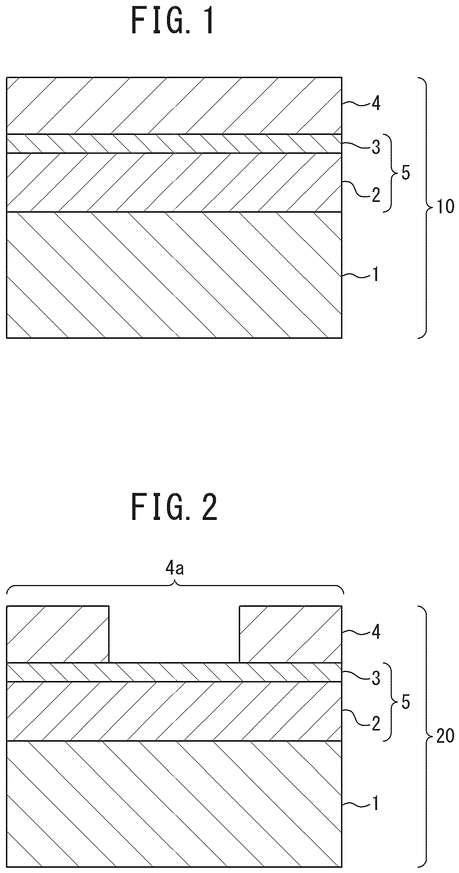

FIG. 1 is a schematic cross-sectional view illustrating the structure of a reflective photomask blank 10 according to an embodiment of the present invention. FIG. 2 is a schematic cross-sectional view illustrating the structure of a reflective photomask 20 according to an embodiment of the present invention. Herein, the reflective photomask 20 according to the embodiment of the present invention illustrated in FIG. 2 is formed by patterning a low reflective part 4 of the reflective photomask blank 10 according to the embodiment of the present invention illustrated in FIG. 1.

(Entire configuration)

As illustrated in FIG. 1, the reflective photomask blank 10 according to the embodiment of the present invention includes a substrate 1, a multi-layer reflective film 2 formed on the substrate 1, and a capping layer 3 formed on the multi-layer reflective film 2. Thus, a reflective part 5 having the multi-layer reflective film 2 and the capping layer 3 is formed on the substrate 1, and a low reflective part 4 is provided on the reflective part 5.

(Substrate)

For the substrate 1 according to the embodiment of the present invention, a flat silicon (Si) substrate, a synthetic quartz substrate, or the like is usable, for example. Further, a low thermal expansion glass to which titanium (Ti) is added is usable for the substrate 1. However, the present invention is not limited to the above insofar as the material has a small thermal expansion coefficient.

(Multi-layer reflective film)

The multi-layer reflective film 2 according to the embodiment of the present invention may be one reflecting an EUV light (extreme ultraviolet light), which is an exposure light, or may be a multi-layer reflective film containing a combination of materials having greatly different refractive indices to the EUV light. As the multi-layer reflective film 2, one formed by repeatedly depositing a layer containing a combination of molybdenum (Mo) and silicon (Si) or molybdenum (Mo) and beryllium (Be) by about 40 cycles may be acceptable, for example.

(Capping layer)

The capping layer 3 according to the embodiment of the present invention is formed of a material having resistance to dry etching performed in forming a transfer pattern (mask pattern) on the low reflective part 4 and functions as an etching stopper to prevent damage to the multi-layer reflective film 2 when the low reflective part 4 is etched. The capping layer 3 is formed of Ru (ruthenium), for example. Herein, the capping layer 3 may not be formed depending on materials of the multi-layer reflective film 2 and the etching conditions. Although not illustrated in the drawings, a back surface conductive film can be formed on the surface on which the multi-layer reflective film 2 is not formed of the substrate 1. The back surface conductive film is a film for fixing the reflective photomask 20 utilizing the principle of an electrostatic chuck when the reflective photomask 20 is installed in an exposure machine.

(Low reflective part)

As illustrated in FIG. 2, a low reflective part pattern 4a of the reflective photomask 20 is formed by removing a part of the low reflective part 4 of the reflective photomask blank 10, i.e., patterning the low reflective part 4. In the EUV lithography, the EUV light is obliquely incident and reflected by the reflective part 5, but the transfer performance onto a wafer (semiconductor substrate) sometimes deteriorates due to a shadowing effect in which the low reflective pattern 4a interferes with an optical path. This deterioration of the transfer performance is reduced by reducing the thickness of the low reflective part 4 absorbing the EUV light. To reduce the thickness of the low reflective part 4, a material having higher absorptivity to the EUV light than that of a conventional material, i.e., a material having a high extinction coefficient k to a wavelength of 13.5 nm, is preferably applied.

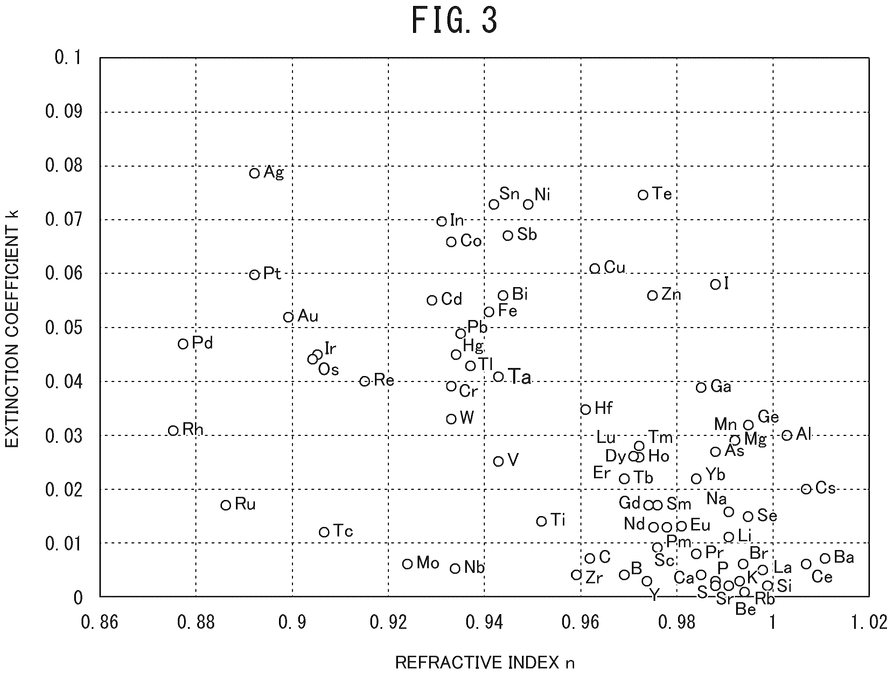

FIG. 3 is a graph showing the optical constants to the wavelength of 13.5 nm of the EUV light of some metal materials. The horizontal axis of FIG. 3 represents the refractive index n and the vertical axis represents the extinction coefficient k. The extinction coefficient k of tantalum (Ta), which is a main material of the conventional low reflective part 4, is 0.041. Materials having a larger extinction coefficient k can further reduce the thickness of the low reflective part 4 than before.

Examples of the materials satisfying the extinction coefficient k described above include silver (Ag), platinum (Pt), indium (In), cobalt (Co), tin (Sn), nickel (Ni), and tellurium (Te), for example, as illustrated in FIG. 3.

When the intensity of a reflected light from the reflective part 5 is set as Rm and the intensity of a reflected light from the low reflective part 4 is set as Ra, an optical density (OD) value, which is an index representing the light intensity contrast between the reflective part 5 and the low reflective part 4, is defined by Expression (1) below.

$$OD = -\log(Ra/Rm) \cdots \text{Equation (1)}$$

When the OD value is larger, the contrast is better and higher transferability is obtained. Although OD > 1 is required for the pattern transfer, the OD value of 1.5 or more is more preferable by comparison with the above-described conventional one.

Compound materials containing Ta as the main ingredient as described above have been applied to the low reflective part 4 of a conventional EUV reflective photomask. In this case, it has been necessary to set the film thickness of the low reflective part 4 to 40 nm or more to obtain the OD value of 1 or more and set the film thickness of the low reflective part 4 to 70 nm or more to obtain the OD value of 2 or more. The extinction coefficient k of tantalum (Ta) is 0.041. When materials having the extinction coefficient k larger than 0.041 are used as the main ingredient, the film thickness of the low reflective part 4 can be reduced as compared with a case where tantalum (Ta) is used as the main ingredient. In particular, oxides of tin (Sn) and indium (In) are desirable as a candidate material for the low reflective part 4 because the oxides enable etching processing by a chlorine-based gas.

For example, the application of a material containing tin (Sn) having the extinction coefficient k of 0.06 or more and oxygen (O) or a material containing indium (In) and oxygen (O) to the low reflective part 4 enables the reduction in the film thickness of the low reflective part 4 to 17 nm when at least the OD value is 1 or more and enables the reduction in the film thickness of the low reflective part 4 to 45 nm or less when the OD value is 2 or more. However, when the film thickness of the low reflective part 4 exceeds 45 nm, the shadowing effect of the low reflective part 4 is substantially equal to that of the low reflective part 4 having a film thickness of 60 nm formed of the conventional compound material containing Ta as the main ingredient.

Therefore, the low reflective part 4 in the embodiment of the present invention contains the materials having the extinction coefficient k larger than 0.041 (hereinafter referred to as a high extinction coefficient material) in a proportion larger than 50 at% and has a film thickness of 45 nm or less. More specifically, when the film thickness of the low reflective part 4 is within the range of 45 nm or less, the shadowing effect can be sufficiently reduced and the transfer performance can be further improved as compared with the conventional low reflective part 4 formed of the compound material containing tantalum (Ta) as the main ingredient. The content of the high extinction coefficient material is preferably 55 at% or more and more preferably 60 at% or more based on the number of atoms of the entire low reflective part 4.

The above-described "main ingredient" refers to an ingredient contained in the proportion of 50 at% or more based on the number of atoms of the entire low reflective part 4.

Further, to transfer a fine pattern, the contrast of the intensity of a light reflected from the reflective part 5 and the low reflective part 4 is desirably high. Therefore, the OD value of the low reflective part 4 is more preferably 1.5 or more.

Among the high extinction coefficient materials, materials containing tin (Sn) and oxygen (O) or materials containing indium (In) and oxygen (O) have excellent etching processability against chlorine gases and have high heat resistance against exposure due to high melting points.

The materials containing tin (Sn) and oxygen (O) among the high extinction coefficient materials also have excellent cleaning resistance.

The reflective photomask 20 is exposed to a hydrogen radical environment, and therefore the reflective photomask 20 cannot withstand long-term use unless the materials constituting the low reflective part 4 are light absorption materials having high hydrogen radical resistance. In this embodiment, a material having a film reduction rate of 0.1 nm/s or less in a hydrogen radical environment in which the power is 1 kW and the hydrogen pressure is 0.36 mbar or less using microwave plasma or a layer formed of the material is used as a material or a layer having high hydrogen radical resistance.

However, the high extinction coefficient materials include materials having low hydrogen radical resistance. For example, when only tin oxide was used as the material constituting the low reflective part 4 or when a material having an atomic number ratio of tin (Sn) and oxygen (O) of 1:2 or less (i.e., the atomic number ratio of tin (Sn) and oxygen (O) (O/Sn) is less than 0.5) was used, it was confirmed that the hydrogen radical resistance was not good.

The atomic number ratio above is a result of measuring a material formed into a film to have a film thickness of 1 $\mu$m by EDX (energy dispersive X-ray analysis).

Herein, a material containing tantalum (Ta) described below and containing at least one of a material group consisting of titanium (Ti), niobium (Nb), tungsten (W), and molybdenum (Mo) (hereinafter also referred to as an additional alloy material) satisfies the requirements as a material enhancing the hydrogen radical resistance of the low reflective part 4.

Tantalum (Ta) is a material contributing to the improvement of the hydrogen radical resistance. The material containing the additional alloy material described above is a material that, when combined with tantalum (Ta), increases the mechanical strength of the entire material and contributes to an improvement of the stability as a compound.

Herein, when the content of tantalum (Ta) is 10 at% or more based on the number of atoms of the entire low reflective part 4 and when the content of the additional alloy material is 2.5 at% or more based on the number of atoms of tantalum (Ta), the film reduction rate of the low reflective part 4 in the hydrogen radical resistance test described above was 0.1 nm/s or less. This has confirmed that the material having the composition described above is a material having high hydrogen radical resistance.

The content of the tantalum (Ta) described above is preferably 15 at% or more and more preferably 20 at% or more based on the number of atoms of the entire low reflective part 4. The content of tantalum (Ta) is preferably less than 50 at% based on the number of atoms of the entire low reflective part 4 because the influence of the transferability of the high extinction coefficient material is high. The content of tantalum (Ta) is more preferably less than 40 at% and still more preferably less than 35 at% based on the number of atoms of the entire low reflective part 4 because the influence of the transferability of the high extinction coefficient material is higher.

The content of the additional alloy material described above is preferably 2.5 at% or more and more preferably 5.0 at% or more based on the number of atoms of tantalum (Ta) because excellent hydrogen radical resistance can be imparted. The content of the additional alloy material is preferably 15 at% or less and more preferably 10 at% or less based on the number of atoms of tantalum (Ta) because the influence on the optical constant of the low reflective part 4 is very low.

As described above, the low reflective part 4 of this embodiment contains the high extinction coefficient material having the extinction coefficient to the EUV light larger than 0.041, tantalum (Ta), and the additional alloy material containing at least one of the material group consisting of titanium (Ti), niobium (Nb), tungsten (W), and molybdenum (Mo), and contains the high extinction coefficient material in a proportion larger than 50 at% based on the total number of atoms constituting the low reflective part 4, in which the content ratio of the additional alloy material in the low reflective part 4 is equal to or less than the content ratio of tantalum (Ta), the total film thickness of the low reflective part 4 is 45 nm or less, and the OD value of the low reflective part 4 is 1.0 or more.

With such a configuration, excellent hydrogen radical resistance is imparted to the low reflective part 4, improving the durability of the low reflective part 4, so that the reflective photomask 20 in which the deterioration of the transferability is reduced and the reflective photomask blank 10 for producing the reflective photomask 20 can be provided.

The content ratio of the additional alloy material in the low reflective part 4 is preferably 2.5 at% or more and more preferably at least 5 at% or more based on the total number of atoms of tantalum (Ta).

The content ratio of titanium (Ti), niobium (Nb), tungsten (W), or molybdenum (Mo) in the low reflective part 4 is 2.5 at% or more based on the total number of atoms of tantalum (Ta) and may be equal to or less than the content ratio of tantalum (Ta) in the low reflective part 4.

The materials constituting the low reflective part 4 contain, for example, beryllium (Be), calcium (Ca), scandium (Sc), vanadium (V), manganese (Mn), iron (Fe), copper (Cu), germanium (Ge), arsenic (As), strontium (Sr), technetium (Tc), rhodium (Rh), barium (Ba), tungsten (W), rhenium (Re), osmium (Os), gold (Au), and the like, and thus can be materials in which the roughness, in-plane dimensional uniformity, and in-plane uniformity of a transferred image are improved and which are sufficiently amorphous.

The materials constituting the low reflective part 4 contain, for example, chromium (Cr), titanium (Ti), aluminum (Al), silicon (Si), zirconium (Zr), vanadium (V), hafnium (Hf), niobium (Nb), yttrium (Y), lead (Pb), gallium (Ga), and the like, and thus can be materials less likely to react with hydrogen radicals and having higher hydrogen radical resistance. The contents of the materials described above are preferably within 1 at% or more and 10 at% or less and more preferably within the range of 2 at% or more and 5 at% or less based on the number of atoms of the entire low reflective part 4.

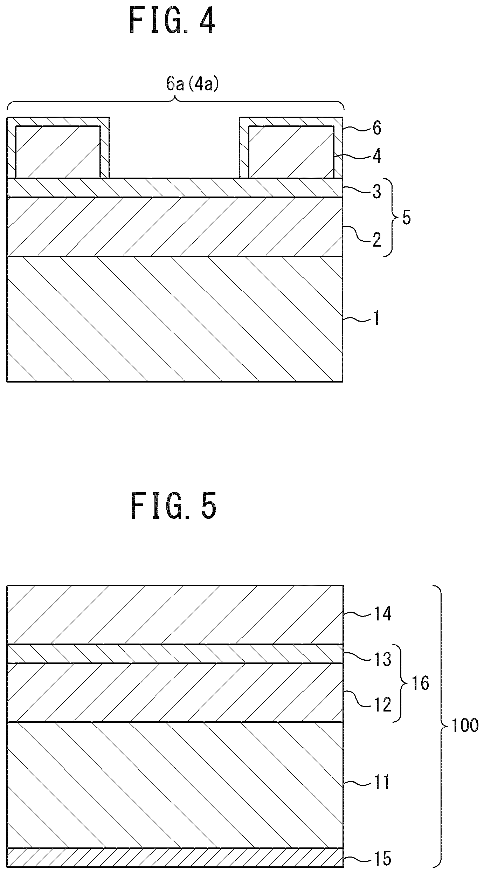

The materials constituting the low reflective part 4 contain, for example, tantalum (Ta), niobium (Nb), chromium (Cr), titanium (Ti), aluminum (Al), vanadium (V), hafnium (Hf), and the like, and thus an oxide film 6 having hydrogen radical resistance can be formed to cover the exposed surface of the low reflective part 4 as illustrated in FIG. 4. The contents of the materials described above are preferably within 1 at% or more and 10 at% or less and more preferably within the range of 2 at% or more and 5 at% or less based on the number of atoms of the entire low reflective part 4.

The materials constituting the low reflective part 4 contain, for example, rhodium (Rh), niobium (Nb), platinum (Pt), titanium (Ti), palladium (Pd), and the like, and thus can be materials having low reactivity to chemical solutions, such as SPM and APM, which are generally used for mask cleaning, and having higher cleaning resistance.

The materials constituting the low reflective part 4 contain, for example, silicon nitride (SiN), tantalum oxide (TaO), and the like, and thus can be materials having high light absorption at a wavelength of 190 nm to 260 nm and inspection light contrast improvability.

The materials constituting the low reflective part 4 contain, for example, cobalt (Co), ruthenium (Ru), iridium (Ir), gold (Au), palladium (Pd), platinum (Pt), molybdenum (Mo), and the like, and thus can be materials having a refractive index n to a wavelength of 13.5 nm less than 0.95 and improving the phase shift property.

Although examples of the effects of the materials that can be contained in the low reflective part 4 are described above, the effects of the materials are not limited to the examples above, and may have two or more of the effects.

The reflective photomask 20 is exposed to a hydrogen radical environment, and therefore the reflective photomask 20 cannot withstand long-term use unless the materials constituting the low reflective part 4 are the materials having high hydrogen radical resistance as described above. In this embodiment, materials having a film reduction rate of 0.1 nm/s or less in a hydrogen radical-rich environment obtained by generating hydrogen plasma using a microwave plasma with a power of 1 kw in a vacuum of 0.36 millibar (mbar) or less are defined as the materials having high hydrogen radical resistance.

In "Hydrogen radical resistance" (Film reduction rate evaluation test) shown in Table 1, the film reduction rate was repeatedly measured two or more times, and a case where the film reduction rate was 0.1 nm/s or less in all the measurements was evaluated as "○", a case where the film reduction of several nm occurred immediately after the start of hydrogen radical treatment but the film reduction rate thereafter was 0.1 nm/s or less was evaluated as "Δ", and a case where the film reduction rate exceeded 0.1 nm/s in all the measurements was evaluated as "×".

Hereinafter, Examples of the reflective photomask blank and the photomask according to the present invention are described.

[Example 1]

As illustrated in FIG. 5, a multi-layer reflective film 12 formed by depositing 40 multi-layer films each containing a pair of silicon (Si) and molybdenum (Mo) is formed on a synthetic quartz substrate 11 having a low thermal expansion property. The film thickness of the multi-layer reflective film 12 was 280 nm.

Next, a capping layer 13 formed of ruthenium (Ru) as an intermediate film was formed to have a film thickness of 2.5 nm on the multi-layer reflective film 12. Thus, a reflective part 16 having the multi-layer reflective film 12 and the capping layer 13 is formed on the substrate 11.

Next, the low reflective part 14 was formed to have a film thickness of 35 nm on the capping layer 13 using a material in which silver oxide (high extinction coefficient material), and tantalum and tungsten (additional alloy materials) were homogeneous in the proportion of 54:45:1. The composition ratio at this time is calculated based on an analysis result by the Rutherford Backscattering Spectrometry (RBS). The crystallinity of the low reflective part 14 was found to be amorphous as measured by XRD (X-ray diffractometer). Thus, the low reflective part 14 is formed on the reflective part 16.

Next, a back surface conductive film 15 formed of chromium nitride was formed with a thickness of 100 nm on the surface on the side where the multi-layer reflective film 12 was not formed of the substrate 11 to produce the reflective photomask blank 100 of Example 1.

A multi-source sputtering apparatus was used for the formation of each film on the substrate 11. The film thickness of each film was controlled by a sputtering time.

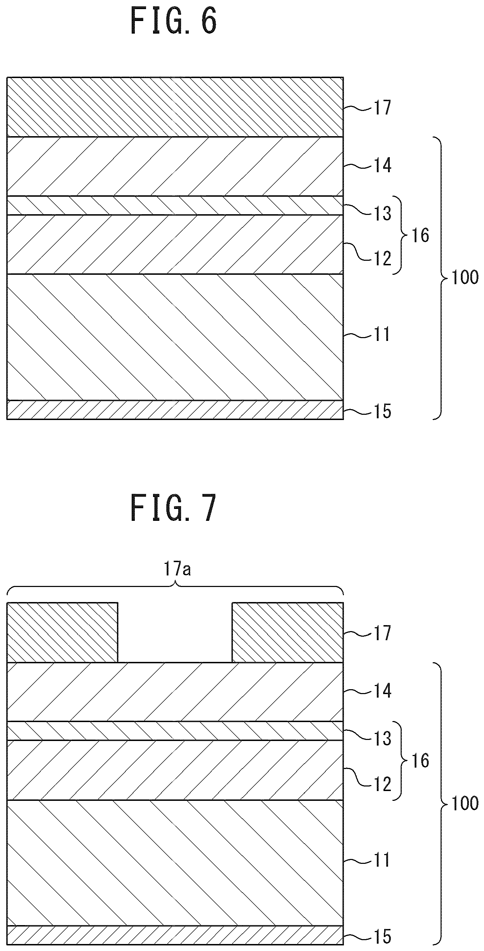

Next, a method for producing a reflective photomask 200 is described using FIGS. 6 to 9.

As illustrated in FIG. 6, a positive chemically amplified resist (SEBP9012: manufactured by Shin-Etsu Chemical Co., Ltd.) was formed on the low reflective part 14 provided in the reflective photomask blank 100 to have a film thickness of 120 nm by spin coating and baked at 110°C for 10 minutes to form a resist film 17.

Next, a predetermined pattern was drawn on the resist film 17 formed of the positive chemically amplified resist by an electron beam drawing machine (JBX3030: manufactured by JEOL Ltd.). Thereafter, baking treatment was performed at 110°C for 10 minutes, and then spray development (SFG3000: manufactured by SIGMAMELTEC LTD.) was performed. Thus, a resist pattern 17a was formed as illustrated in FIG. 7.

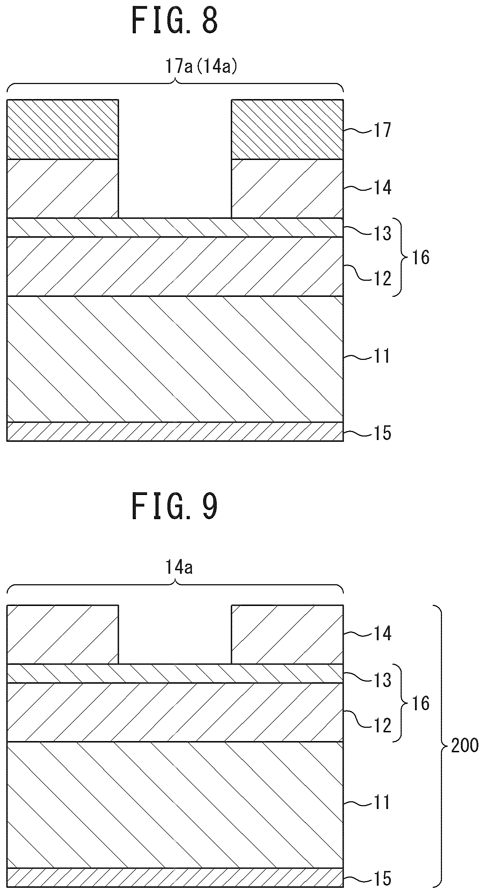

Next, the low reflective part 14 was patterned by dry etching mainly using a chlorine-based gas to form a low reflective part pattern. Thus, a low reflective part pattern 14a was formed as illustrated in FIG. 8.

Next, the remaining resist pattern 17a was peeled off, thereby producing the reflective photomask 200 according to this example as illustrated in FIG. 9.

Next, the reflective photomask 200 according to this example was dipped in sulfuric acid at 80°C for 10 minutes, dipped in a cleaning tank filled with a cleaning liquid obtained by mixing ammonia, hydrogen peroxide, and water in the proportion of 1:1:20 for 10 minutes using a 500 W megasonic waves, and then cleaned by flowing water for 10 minutes. Thereafter, the film thickness was measured by atomic force microscope (AFM) and compared with the film thickness in the film formation, but no changes in the film thickness were observed. This result shows that the reflective photomask 200 according to this example has excellent cleaning resistance.

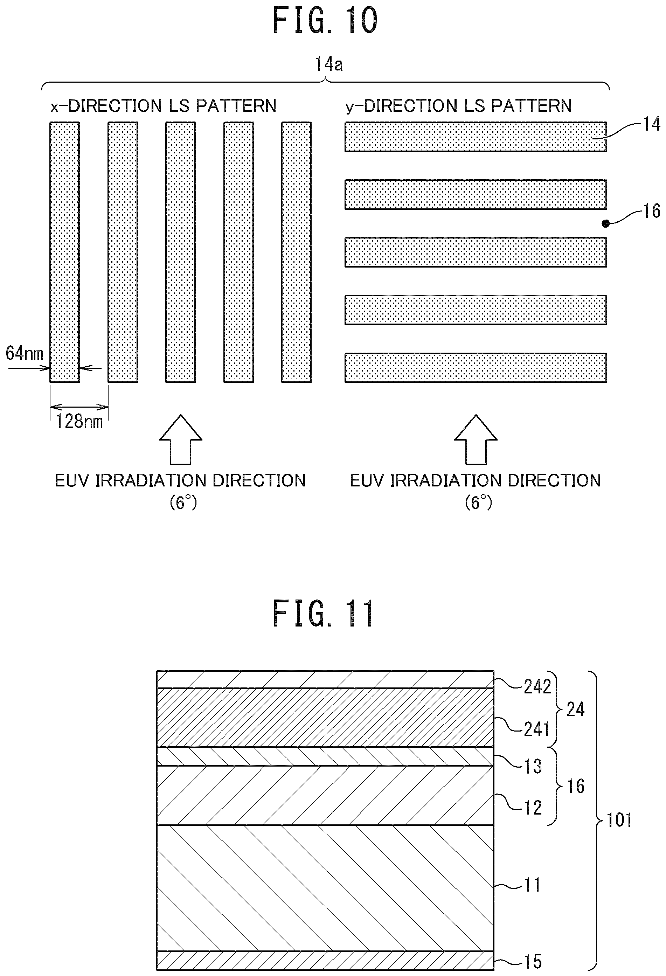

In this example, the low reflective part pattern 14a formed on the low reflective part 14 contains an LS (line and space) pattern with a line width of 64 nm, an LS pattern with a line width of 200 nm for measuring the film thickness of the low reflective part 14 using AFM, and a 4 mm square low reflective part removed part for EUV reflectance measurement on the reflective photomask 200 for transfer evaluation. The LS pattern with a line width of 64 nm was designed in each of the x-direction and the y-direction as illustrated in FIG. 10 such that the influence of the shadowing effect by the oblique irradiation of the EUV was able to be easily viewed.

[Example 2]

The low reflective part 14 was formed to have a film thickness of 35 nm using a material in which silver oxide (high extinction coefficient material), and tantalum and tungsten (additional alloy materials) were homogeneous in the proportion of 53.9:44:2.1. The composition ratio at this time is calculated based on an analysis result by the Rutherford Backscattering Spectrometry (RBS). The crystallinity of the low reflective part 14 was found to be amorphous as measured by XRD (X-ray diffractometer). Thus, the low reflective part 14 is formed on the reflective part 16. The reflective photomask blank 100 and the reflective photomask 200 of Example 2 were produced in the same manner as in Example 1, except for the low reflective part 14.

[Example 3]

The low reflective part 14 was formed to have a film thickness of 35 nm using a material in which tin oxide (high extinction coefficient material), and tantalum and tungsten (additional alloy materials) were homogeneous in the proportion of 53.9:44:2.1. The composition ratio at this time is calculated based on an analysis result by the Rutherford Backscattering Spectrometry (RBS). The crystallinity of the low reflective part 14 was found to be amorphous as measured by XRD (X-ray diffractometer). Thus, the low reflective part 14 is formed on the reflective part 16. The reflective photomask blank 100 and the reflective photomask 200 of Example 3 were produced in the same manner as in Example 1, except for the low reflective part 14.

[Example 4]

The low reflective part 14 was formed to have a film thickness of 26 nm using a material in which silver oxide (high extinction coefficient material), and tantalum and tungsten (additional alloy materials) were homogeneous in the proportion of 78:20:2. The composition ratio at this time is calculated based on an analysis result by the Rutherford Backscattering Spectrometry (RBS). The crystallinity of the low reflective part 14 was found to be amorphous as measured by XRD (X-ray diffractometer). Thus, the low reflective part 14 is formed on the reflective part 16. The reflective photomask blank 100 and the reflective photomask 200 of Example 4 were produced in the same manner as in Example 1, except for the low reflective part 14.

[Example 5]

The low reflective part 14 was formed to have a film thickness of 26 nm using a material in which tin oxide (high extinction coefficient material), and tantalum and tungsten (additional alloy materials) were homogeneous in the proportion of 78:20:2. The composition ratio at this time is calculated based on an analysis result by the Rutherford Backscattering Spectrometry (RBS). The crystallinity of the low reflective part 14 was found to be amorphous as measured by XRD (X-ray diffractometer). Thus, the low reflective part 14 is formed on the reflective part 16. The reflective photomask blank 100 and the reflective photomask 200 of Example 5 were produced in the same manner as in Example 1, except for the low reflective part 14.

[Example 6]

The low reflective part 14 was formed to have a film thickness of 26 nm using a material in which indium oxide (high extinction coefficient material), and tantalum and tungsten (additional alloy materials) were homogeneous in the proportion of 78:20:2. The composition ratio at this time is calculated based on an analysis result by the Rutherford Backscattering Spectrometry (RBS). The crystallinity of the low reflective part 14 was found to be amorphous as measured by XRD (X-ray diffractometer). Thus, the low reflective part 14 is formed on the reflective part 16. The reflective photomask blank 100 and the reflective photomask 200 of Example 6 were produced in the same manner as in Example 1, except for the low reflective part 14.

[Example 7]

The low reflective part 14 was formed to have a film thickness of 26 nm using a material in which tin oxide (high extinction coefficient material), and tantalum and titanium (additional alloy materials) were homogeneous in the proportion of 78:20:2. The composition ratio at this time is calculated based on an analysis result by the Rutherford Backscattering Spectrometry (RBS). The crystallinity of the low reflective part 14 was found to be amorphous as measured by XRD (X-ray diffractometer). Thus, the low reflective part 14 is formed on the reflective part 16. The reflective photomask blank 100 and the reflective photomask 200 of Example 7 were produced in the same manner as in Example 1, except for the low reflective part 14.

[Example 8]

The low reflective part 14 was formed to have a film thickness of 26 nm using a material in which tin oxide (high extinction coefficient material), and tantalum and niobium (additional alloy materials) were homogeneous in the proportion of 78:20:2. The composition ratio at this time is calculated based on an analysis result by the Rutherford Backscattering Spectrometry (RBS). The crystallinity of the low reflective part 14 was found to be amorphous as measured by XRD (X-ray diffractometer). Thus, the low reflective part 14 is formed on the reflective part 16. The reflective photomask blank 100 and the reflective photomask 200 of Example 8 were produced in the same manner as in Example 1, except for the low reflective part 14.

[Example 9]

The low reflective part 14 was formed to have a film thickness of 26 nm using a material in which tin oxide (high extinction coefficient material), and tantalum and molybdenum (additional alloy materials) were homogeneous in the proportion of 78:20:2. The composition ratio at this time is calculated based on an analysis result by the Rutherford Backscattering Spectrometry (RBS). The crystallinity of the low reflective part 14 was found to be amorphous as measured by XRD (X-ray diffractometer). Thus, the low reflective part 14 is formed on the reflective part 16. The reflective photomask blank 100 and the reflective photomask 200 of Example 9 were produced in the same manner as in Example 1, except for the low reflective part 14.

[Comparative Example 1]

The low reflective part 14 was formed to have a film thickness of 35 nm using a material in which silver oxide (high extinction coefficient material) and tantalum (additional alloy material) were homogeneous in the proportion of 55:45. The composition ratio at this time is calculated based on an analysis result by the Rutherford Backscattering Spectrometry (RBS). The crystallinity of the low reflective part 14 was found to be amorphous as measured by XRD (X-ray diffractometer). Thus, the low reflective part 14 is formed on the reflective part 16. The reflective photomask blank 100 and the reflective photomask 200 of Comparative Example 1 were produced in the same manner as in Example 1, except for the low reflective part 14.

[Comparative Example 2]

As illustrated in FIG. 11, an absorption layer 241 was formed of tantalum nitride to have a film thickness of 58 nm. An outermost layer 242 was formed of tantalum oxide to have a film thickness of 2 nm. Thus, a low reflective part 24 having the absorption layer 241 and the outermost layer 242 is formed on the reflective part 16. This comparative example assumes a reflective photomask using a conventional existing film containing tantalum as the main ingredient.

However, tantalum nitride and tantalum oxide are separated in the upper layer and the lower layer, and the film is not a film in which the compositions continuously change.

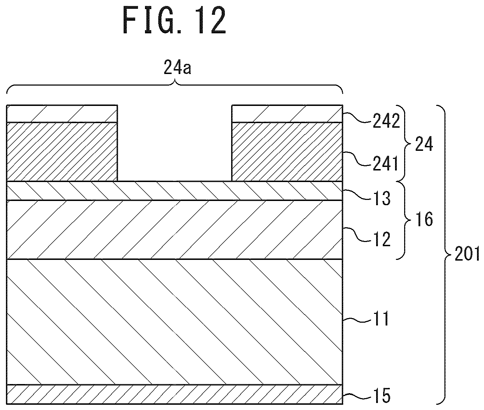

A reflective photomask blank 101 and a reflective photomask 201 including a low reflective part pattern 24a of Comparative Example 2 illustrated in FIG. 11 and FIG. 12, respectively, were produced in the same manner as in Example 1, except for the formation of the absorption layer 241 and the outermost layer 242.

The reflectance Rm of a reflective part region and the reflectance Ra of a low reflective part region of the reflective photomask produced in each of Examples and Comparative Examples were measured by a reflectance measuring device using the EUV light. The reflectance Rm was measured in the 4 mm square low reflective part removed part. From the measurement results, the OD value was calculated using Equation (1) above.

(Wafer exposure evaluation)

Using an EUV exposure apparatus (NXE3300B: manufactured by ASML), the low reflective part patterns 14a, 24a of the reflective photomasks produced in Examples and Comparative Examples each were transferred and exposed onto a semiconductor wafer coated with an EUV positive chemically amplified resist. At this time, the exposure amount was adjusted such that the x-direction LS pattern illustrated in FIG. 10 was transferred as designed. Thereafter, a transferred resist pattern was observed and measured for the line width by an electron beam dimension measuring machine, thereby confirming the resolution.

At this time, the HV-bias of 6.1 nm of the existing film was evaluated as "Δ", a case where the HV-bias was less than 6.1 nm was evaluated as "o", and a case where the HV-bias was 4.5 nm or less was evaluated as "◎". A case where the OD value was 1.5 or more was evaluated as "o" and a case where the OD value was 1.6 or more was evaluated as "◎". For the HV-bias, those having the evaluation equal to or higher than "Δ" have no problems in use, and therefore were accepted. For the OD value, those having the evaluation equal to or higher than "o" have no problems in use, and therefore were accepted.

Table 1 shows these evaluation results.

[Table 1]

| | Absorption layer | | Upper layer of absorption layer | | Low reflective part | Resist pattern on wafer | | Hydrogen radical resistance | Cleaning resistance | Determination |
|---|---|---|---|---|---|---|---|---|---|---|
| | Material | Film thickness | Material | Film thickness | Total film thickness | OD value | Pattern transferability | | | |
| Ex. 1 | AgO: 54%<br>Ta: 45%<br>W: 1% | 35 nm | - | - | 35 nm | ◎ (2.5) | ○ (HV bias of 5.7 nm) | Δ | Observed | Δ |
| Ex. 2 | AgO: 53.9%<br>Ta: 44%<br>W: 2.1 % | 35 nm | - | - | 35 nm | ◎ (2.4) | ○ (HV bias of 5.6 nm) | ○ | Observed | ○ |
| Ex. 3 | SnO: 53.9%<br>Ta: 44%<br>W: 2.1% | 35 nm | - | - | 35 nm | ◎ (1.7) | ○ (HV bias of 4.6 nm) | ○ | Observed | ○ |
| Ex. 4 | AgO: 78%<br>Ta: 20%<br>W: 2% | 26 nm | - | - | 26 nm | ◎ (1.6) | ◎ (HV bias of 3.8 nm) | ○ | Observed | ○ |
| Ex. 5 | SnO: 78%<br>Ta: 20%<br>W: 2% | 26 nm | - | - | 26 nm | ◎ (1.7) | ◎ (HV bias of 3.0 nm) | ○ | Observed | ○ |
| Ex. 6 | Ino: 78%<br>Ta: 20%<br>W: 2% | 26 nm | - | - | 26 nm | ◎ (1.7) | ◎ (HV bias of 3.0 nm) | ○ | Observed | ○ |
| Ex. 7 | SnO: 78%<br>Ta: 20%<br>Ti: 2% | 26 nm | - | - | 26 nm | ◎ (1.7) | ◎ (HV bias of 3.0 nm) | ○ | Observed | ○ |
| Ex. 8 | SnO: 78%<br>Ta: 20%<br>Nb: 2% | 26 nm | - | - | 26 nm | ◎ (1.7) | ◎ (HV bias of 3.0 nm) | ○ | Observed | ○ |
| Ex. 9 | SnO: 78%<br>Ta: 20%<br>Mo: 2% | 26 nm | - | - | 26 nm | ◎ (1.7) | ◎ (HV bias of 3.0 nm) | ○ | Observed | ○ |

(continued)

| | Absorption layer | | Upper layer of absorption layer | | Low reflective part | Resist pattern on wafer | | Hydrogen radical resistance | Cleaning resistance | Determination |
|---|---|---|---|---|---|---|---|---|---|---|
| | Material | Film thickness | Material | Film thickness | Total film thickness | OD value | Pattern transferability | | | |
| Comp. Ex. 1 | AgO: 55% Ta: 45% | 35 nm | - | - | 35 nm | ◎ (2.4) | ○ (HV bias of 5.7 nm) | × | Observed | × |
| Comp. Ex. 2 | TaN (Existing) | 58 nm | TaO (Existing) | 2 nm | 60 nm | o (1.5) | △ (HV bias of 6.1 nm) | ○ | Observed | △ |

Table 1 shows, in Comparative Example 2, the resist pattern dimension on the wafer and the mask characteristics of the photomask in the existing Ta-based film in which the absorption layer 241 contains tantalum nitride and has a film thickness of 58 nm and the outermost layer 242 contains tantalum oxide and has a film thickness of 2 nm. In the case of the reflective photomask 201 of Comparative Example 2, the film reduction rate by the hydrogen radical resistance evaluation was 0.1 nm/s or less. The OD value was 1.5, and the contrast enabling pattern transfer was obtained. As a result of the patterning by the EUV light, a result was obtained that the H-V bias (horizontal-vertical dimensional difference) was 6.1 nm, and the pattern was resolved, but the influence of the shadowing effect was large, and thus the transferability was low.

The reflective photomask 201 according to Comparative Example 2 was dipped in sulfuric acid at 80°C for 10 minutes, dipped in a cleaning tank filled with a cleaning liquid obtained by mixing ammonia, hydrogen peroxide, and water in the proportion of 1:1:20 for 10 minutes using a 500 W megasonic waves, and then cleaned by flowing water for 10 minutes. Thereafter, the film thickness was compared with the film thickness in the film formation, but no changes in the film thickness were observed. This result showed that reflective photomask 201 of Comparative Example 2 has excellent cleaning resistance.

Table 1 shows, in Example 1, the resist pattern dimension on the wafer and the mask characteristics of the photomask in which the low reflective part 14 is formed using the material in which silver oxide (high extinction coefficient material), and tantalum and tungsten (additional alloy materials) were homogeneous in the proportion of 54:45:1 and the film thickness is 35 nm. In the case of the reflective photomask 200 of Example 1, the film reduction of 1 nm occurred immediately after the start of the hydrogen radical treatment, but no film reduction was observed after that. The OD value was 2.5, and the contrast enabling pattern transfer was obtained. As a result of the patterning by the EUV light, a result was obtained that the H-V bias was 5.7 nm, and the pattern transferability superior to that of Comparative Example 2 was obtained.

The reflective photomask 200 according to Example 1 was dipped in sulfuric acid at 80°C for 10 minutes, dipped in a cleaning tank filled with a cleaning liquid obtained by mixing ammonia, hydrogen peroxide, and water in the proportion of 1:1:20 for 10 minutes using a 500 W megasonic waves, and then cleaned by flowing water for 10 minutes. Thereafter, the film thickness was compared with the film thickness in the film formation, but no changes in the film thickness were observed. This result showed that reflective photomask 200 of Example 1 has excellent cleaning resistance.

Table 1 shows, in Example 2, the resist pattern dimension on the wafer and the mask characteristics of the photomask in which the low reflective part 14 is formed using the material in which silver oxide (high extinction coefficient material), and tantalum and tungsten (additional alloy materials) were homogeneous in the proportion of 53.9:44:2.1 and the film thickness is 35 nm. In the case of the reflective photomask 200 of Example 2, the film reduction by the hydrogen radical resistance evaluation was not observed, and excellent hydrogen radical resistance was obtained. The OD value was 2.4, and the contrast enabling pattern transfer was obtained. As a result of the patterning by the EUV light, a result was obtained that the H-V bias was 5.6 nm, and the pattern transferability superior to that of Comparative Example 2 was obtained.

The reflective photomask 200 according to Example 2 was dipped in sulfuric acid at 80°C for 10 minutes, dipped in a cleaning tank filled with a cleaning liquid obtained by mixing ammonia, hydrogen peroxide, and water in the proportion of 1:1:20 for 10 minutes using a 500 W megasonic waves, and then cleaned by flowing water for 10 minutes. Thereafter, the film thickness was compared with the film thickness in the film formation, but no changes in the film thickness were observed. This result showed that reflective photomask 200 of Example 2 has excellent cleaning resistance.

Table 1 shows, in Example 3, the resist pattern dimension on the wafer and the mask characteristics of the photomask in which the low reflective part 14 is formed using the material in which tin oxide (high extinction coefficient material), and tantalum and tungsten (additional alloy materials) were homogeneous in the proportion of 53.9:44:2.1 and the film thickness is 35 nm. In the case of the reflective photomask 200 of Example 3, the film reduction by the hydrogen radical resistance evaluation was not observed, and excellent hydrogen radical resistance was obtained. The OD value was 1.7, and the contrast enabling pattern transfer was obtained. As a result of the patterning by the EUV light, a result was obtained that the H-V bias was 4.6 nm, and the pattern transferability superior to that of Comparative Example 2 was obtained.

The reflective photomask 200 according to Example 3 was dipped in sulfuric acid at 80°C for 10 minutes, dipped in a cleaning tank filled with a cleaning liquid obtained by mixing ammonia, hydrogen peroxide, and water in the proportion of 1:1:20 for 10 minutes using a 500 W megasonic waves, and then cleaned by flowing water for 10 minutes. Thereafter, the film thickness was compared with the film thickness in the film formation, but no changes in the film thickness were observed. This result showed that reflective photomask 200 of Example 3 has excellent cleaning resistance.

Table 1 shows, in Example 4, the resist pattern dimension on the wafer and the mask characteristics of the photomask in which the low reflective part 14 is formed using the material in which silver oxide (high extinction coefficient material), and tantalum and tungsten (additional alloy materials) were homogeneous in the proportion of 78:20:2 and the film thickness is 26 nm. In the case of the reflective photomask 200 of Example 4, the film reduction by the hydrogen radical resistance evaluation was not observed, and excellent hydrogen radical resistance was obtained. The OD value was 1.6, and the contrast enabling pattern transfer was obtained. As a result of the patterning by the EUV light, a result was obtained that the H-V bias was 3.8 nm, and the pattern transferability superior to that of Comparative Example 2 was obtained.

The reflective photomask 200 according to Example 4 was dipped in sulfuric acid at 80°C for 10 minutes, dipped in a cleaning tank filled with a cleaning liquid obtained by mixing ammonia, hydrogen peroxide, and water in the proportion of 1:1:20 for 10 minutes using a 500 W megasonic waves, and then cleaned by flowing water for 10 minutes. Thereafter, the film thickness was compared with the film thickness in the film formation, but no changes in the film thickness were observed. This result showed that reflective photomask 200 of Example 4 has excellent cleaning resistance.

Table 1 shows, in Example 5, the resist pattern dimension on the wafer and the mask characteristics of the photomask in which the low reflective part 14 is formed using the material in which tin oxide (high extinction coefficient material), and tantalum and tungsten (additional alloy materials) were homogeneous in the proportion of 78:20:2 and the film thickness is 26 nm. In the case of the reflective photomask 200 of Example 5, the film reduction by the hydrogen radical resistance evaluation was not observed, and excellent hydrogen radical resistance was obtained. The OD value was 1.7, and the contrast enabling pattern transfer was obtained. As a result of the patterning by the EUV light, a result was obtained that the H-V bias was 3.0 nm, and the pattern transferability superior to that of Comparative Example 2 was obtained.

The reflective photomask 200 according to Example 5 was dipped in sulfuric acid at 80°C for 10 minutes, dipped in a cleaning tank filled with a cleaning liquid obtained by mixing ammonia, hydrogen peroxide, and water in the proportion of 1:1:20 for 10 minutes using a 500 W megasonic waves, and then cleaned by flowing water for 10 minutes. Thereafter, the film thickness was compared with the film thickness in the film formation, but no changes in the film thickness were observed. This result showed that reflective photomask 200 of Example 5 has excellent cleaning resistance.

Table 1 shows, in Example 6, the resist pattern dimension on the wafer and the mask characteristics of the photomask in which the low reflective part 14 is formed using the material in which indium oxide (high extinction coefficient material), and tantalum and tungsten (additional alloy materials) were homogeneous in the proportion of 78:20:2 and the film thickness is 26 nm. In the case of the reflective photomask 200 of Example 6, the film reduction by the hydrogen radical resistance evaluation was not observed, and excellent hydrogen radical resistance was obtained. The OD value was 1.7, and the contrast enabling pattern transfer was obtained. As a result of the patterning by the EUV light, a result was obtained that the H-V bias was 3.0 nm, and the pattern transferability superior to that of Comparative Example 2 was obtained.

The reflective photomask 200 according to Example 6 was dipped in sulfuric acid at 80°C for 10 minutes, dipped in a cleaning tank filled with a cleaning liquid obtained by mixing ammonia, hydrogen peroxide, and water in the proportion of 1:1:20 for 10 minutes using a 500 W megasonic waves, and then cleaned by flowing water for 10 minutes. Thereafter, the film thickness was compared with the film thickness in the film formation, but no changes in the film thickness were observed. This result showed that reflective photomask 200 of Example 6 has excellent cleaning resistance.

Table 1 shows, in Example 7, the resist pattern dimension on the wafer and the mask characteristics of the photomask in which the low reflective part 14 is formed using the material in which tin oxide (high extinction coefficient material), and tantalum and titanium (additional alloy materials) were homogeneous in the proportion of 78:20:2 and the film thickness is 26 nm. In the case of the reflective photomask 200 of Example 7, the film reduction by the hydrogen radical resistance evaluation was not observed, and excellent hydrogen radical resistance was obtained. The OD value was 1.7, and the contrast enabling pattern transfer was obtained. As a result of the patterning by the EUV light, a result was obtained that the H-V bias was 3.0 nm, and the pattern transferability superior to that of Comparative Example 2 was obtained.

The reflective photomask 200 according to Example 7 was dipped in sulfuric acid at 80°C for 10 minutes, dipped in a cleaning tank filled with a cleaning liquid obtained by mixing ammonia, hydrogen peroxide, and water in the proportion of 1:1:20 for 10 minutes using a 500 W megasonic waves, and then cleaned by flowing water for 10 minutes. Thereafter, the film thickness was compared with the film thickness in the film formation, but no changes in the film thickness were observed. This result showed that reflective photomask 200 of Example 7 has excellent cleaning resistance.

Table 1 shows, in Example 8, the resist pattern dimension on the wafer and the mask characteristics of the photomask in which the low reflective part 14 is formed using the material in which tin oxide (high extinction coefficient material), and tantalum and niobium (additional alloy materials) were homogeneous in the proportion of 78:20:2 and the film thickness is 26 nm. In the case of the reflective photomask 200 of Example 8, the film reduction by the hydrogen radical resistance evaluation was not observed, and excellent hydrogen radical resistance was obtained. The OD value was 1.7, and the contrast enabling pattern transfer was obtained. As a result of the patterning by the EUV light, a result was obtained that the H-V bias was 3.0 nm, and the pattern transferability superior to that of Comparative Example 2 was obtained.

The reflective photomask 200 according to Example 8 was dipped in sulfuric acid at 80°C for 10 minutes, dipped in a cleaning tank filled with a cleaning liquid obtained by mixing ammonia, hydrogen peroxide, and water in the proportion of 1:1:20 for 10 minutes using a 500 W megasonic waves, and then cleaned by flowing water for 10 minutes. Thereafter, the film thickness was compared with the film thickness in the film formation, but no changes in the film thickness were observed. This result showed that reflective photomask 200 of Example 8 has excellent cleaning resistance.

Table 1 shows, in Example 9, the resist pattern dimension on the wafer and the mask characteristics of the photomask in which the low reflective part 14 is formed using the material in which tin oxide (high extinction coefficient material), and tantalum and molybdenum (additional alloy materials) were homogeneous in the proportion of 78:20:2 and the film thickness is 26 nm. In the case of the reflective photomask 200 of Example 9, the film reduction by the hydrogen radical resistance evaluation was not observed, and excellent hydrogen radical resistance was obtained. The OD value was 1.7, and the contrast enabling pattern transfer was obtained. As a result of the patterning by the EUV light, a result was obtained that the H-V bias was 3.0 nm, and the pattern transferability superior to that of Comparative Example 2 was obtained.

The reflective photomask 200 according to Example 9 was dipped in sulfuric acid at 80°C for 10 minutes, dipped in a cleaning tank filled with a cleaning liquid obtained by mixing ammonia, hydrogen peroxide, and water in the proportion of 1:1:20 for 10 minutes using a 500 W megasonic waves, and then cleaned by flowing water for 10 minutes. Thereafter, the film thickness was compared with the film thickness in the film formation, but no changes in the film thickness were observed. This result showed that reflective photomask 200 of Example 9 has excellent cleaning resistance.

Table 1 shows, in Comparative Example 1, the resist pattern dimension on the wafer and the mask characteristics of the photomask in which the low reflective part 14 is formed using the material in which silver oxide (high extinction coefficient material) and tantalum (additional alloy material) were homogeneous in the proportion of 55:45 and the film thickness is 35 nm. In the case of the reflective photomask 200 of Comparative Example 1, the film reduction by the hydrogen radical resistance evaluation was 0.11 nm/s. The OD value was 2.4, and the contrast enabling pattern transfer was obtained. As a result of the patterning by the EUV light, a result was obtained that the H-V bias was 5.7 nm, and the pattern transferability superior to that of Comparative Example 2 was obtained.

The reflective photomask 200 according to Comparative Example 1 was dipped in sulfuric acid at 80°C for 10 minutes, dipped in a cleaning tank filled with a cleaning liquid obtained by mixing ammonia, hydrogen peroxide, and water in the proportion of 1:1:20 for 10 minutes using a 500 W megasonic waves, and then cleaned by flowing water for 10 minutes. Thereafter, the film thickness was compared with the film thickness in the film formation, but no changes in the film thickness were observed. This result showed that reflective photomask 200 of Comparative Example 1 has excellent cleaning resistance.

A comparison between Example 1 and the existing film (Comparative Example 2) showed that the hydrogen radical resistance of the reflective photomask of Example 1 was slightly inferior to the reflective photomask using the existing film, but the pattern transferability of the reflective photomask of Example 1 was superior to that of the reflective photomask using the existing film. In the reflective photomask of Example 1, the hydrogen radical resistance is slightly inferior to that of the existing film and the pattern transferability is superior to that of the existing film, and therefore the determination result is indicated as "Δ" and treated as "pass".

A comparison between each of Examples 2 to 9 and the existing film (Comparative Example 2) showed that the hydrogen radical resistance of the reflective photomask of each of Examples 2 to 9 was substantially equal to that of the reflective photomask using the existing film, and the pattern transferability of the reflective photomask of each of Examples 2 to 9 was superior to that of the reflective photomask using the existing film. In the reflective photomask of each of Examples 2 to 9, both the hydrogen radical resistance and the pattern transferability are superior to those of the existing film (Comparative Example 2), and therefore the determination results are indicated as "○" and treated as "pass".

In the reflective photomask of Comparative Example 1, the hydrogen radical resistance is clearly inferior to that of the existing film (Comparative Example 2), and therefore the determination result is indicated as "×" and treated as "failure".

Thus, in the case of the reflective photomask 200 in which the low reflective part 14 contains the high extinction coefficient material which is the material having the extinction coefficient to the EUV light larger than 0.041 in the proportion larger than 50 at%, contains tantalum (Ta), and contains at least one of a material group consisting of titanium (Ti), niobium (Nb), tungsten (W), and molybdenum (Mo), the content ratio (content ratio of the additional alloy material) is equal to or less than the content ratio of tantalum (Ta) contained in the low reflective part 14, the film thickness is 45 nm or less, and the OD value is 1.0 or more, a result was obtained that the pattern transferability and the hydrogen radical resistance are good, the shadowing effect can be reduced, the lifespan is long, and the transfer performance is enhanced. More specifically, it was able to be confirmed that the reflective photomask 200 having more excellent transfer performance can be obtained. In other words, it can be said that it was able to be confirmed that the use of the reflective photomask blank 100 according to this embodiment enables the production of the reflective photomask 200 capable of suppressing or reducing the shadowing effect of the reflective photomask for patterning transfer using a light having a wavelength in the extreme ultraviolet region as a light source and having excellent hydrogen radical resistance.

Industrial Applicability

The reflective photomask blank and the reflective photomask according to the present invention can be suitably used for forming a fine pattern by EUV exposure in a manufacturing process of a semiconductor integrated circuit and the like.

Reference Signs List

| | |
|---|---|
| 1 | substrate |
| 2 | multi-layer reflective film |
| 3 | capping layer |
| 4 | low reflective part |
| 4a | low reflective part pattern |
| 5 | reflective part |
| 6 | oxide film |
| 6a | oxide film pattern |
| 10 | reflective photomask blank |
| 20 | reflective photomask |
| 11 | substrate |
| 12 | multi-layer reflective film |
| 13 | capping layer |
| 14 | low reflective part |
| 14a | low reflective part pattern |
| 24 | low reflective part |
| 241 | absorption layer |
| 242 | outermost layer |
| 24a | low reflective part pattern |
| 15 | back surface conductive film |
| 16 | reflective part |
| 17 | resist film |
| 17a | resist pattern |
| 100 | reflective photomask blank |
| 200 | reflective photomask |
| 101 | reflective photomask blank |
| 201 | reflective photomask |

**Claims**

1. A reflective photomask blank (10) for producing a reflective photomask (20) for pattern transfer using an extreme ultraviolet light as a light source, the reflective photomask blank comprising:

   a substrate (1);
   a reflective part (5) formed on the substrate (1) and configured to reflect an incident light; and
   a low reflective part (4) formed on the reflective part (5) and configured to absorb an incident light, wherein
   the reflective part (5) includes a multi-layer reflective film (2) and a capping layer (3),
   the low reflective part (4) contains a high extinction coefficient material which is a material having an extinction coefficient to an EUV light larger than 0.041, tantalum (Ta), and at least one of a material group consisting of titanium (Ti), niobium (Nb), tungsten (W), and molybdenum (Mo) and contains the high extinction coefficient material in a proportion larger than 50 at%,
   a content ratio of the at least one of the material group consisting of the titanium (Ti), the niobium (Nb), the tungsten (W), and the molybdenum (Mo) in the low reflective part (4) is equal to or less than a content ratic of the tantalum (Ta),
   a total film thickness of the low reflective part (4) is 45 nm or less, and
   an OD (Optical Density) value of the low reflective part (4) is 1.0 or more.

2. The reflective photomask blank according to claim 1, wherein the content ratio of the at least one of the material group consisting of the titanium (Ti), the niobium (Nb), the tungsten (W), and the molybdenum (Mo) in the low reflective part is 2.5 at% or more based on a total number of atoms of the tantalum (Ta).

3. The reflective photomask blank according to claim 1, wherein the content ratio of the at least one of the material group consisting of the titanium (Ti), the niobium (Nb), the tungsten (W), and the molybdenum (Mo) in the low reflective part is 5 at% or more based on a total number of atoms of the tantalum (Ta).

4. The reflective photomask blank according to claim 1, wherein a content ratio of the titanium (Ti), the niobium (Nb), the tungsten (W), and the molybdenum (Mo) in the low reflective part is 2.5 at% or more based on a total number of atoms of the tantalum (Ta) and equal to or less than the content ratio of the tantalum (Ta).

5. The reflective photomask blank according to any one of claims 2 to 4, wherein the low reflective part contains at least one of a material containing tin (Sn) and oxygen (O) and a material containing indium (In) and oxygen (O) as the high extinction coefficient material.

6. A reflective photomask (20) for pattern transfer using an extreme ultraviolet light as a light source, the reflective photomask (20) comprising:

a substrate (1);
a reflective part (5) formed on the substrate (1) and configured to reflect an incident light; and
a low reflective part (4) formed on the reflective part (5) and configured to absorb an incident light, wherein
the reflective part (5) includes a multi-layer reflective film (2) and a capping layer (3),
the low reflective part (4) contains a high extinction coefficient material which is a material having an extinction coefficient to an EUV light larger than 0.041, tantalum (Ta), and at least one of a material group consisting of titanium (Ti), niobium (Nb), tungsten (W), and molybdenum (Mo) and contains the high extinction coefficient material in a proportion larger than 50 at%,
a content ratio of the at least one of the material group consisting of the titanium (Ti), the niobium (Nb), the tungsten (W), and the molybdenum (Mo) in the low reflective part (4) is equal to or less than a content ratio of the tantalum (Ta),
a total film thickness of the low reflective part (4) is 45 nm or less, and an OD (Optical Density) value of the low reflective part (4) is 1.0 or more.

7. The reflective photomask according to claim 6, wherein the content ratio of the at least one of the material group consisting of the titanium (Ti), the niobium (Nb), the tungsten (W), and the molybdenum (Mo) in the low reflective part is 2.5 at% or more based on a total number of atoms of the tantalum (Ta).

8. The reflective photomask according to claim 6, wherein the content ratio of the at least one of the material group consisting of the titanium (Ti), the niobium (Nb), the tungsten (W), and the molybdenum (Mo) in the low reflective part is 5 at% or more based on a total number of atoms of the tantalum (Ta).

9. The reflective photomask according to claim 6, wherein a content ratio of the titanium (Ti), the niobium (Nb), the tungsten (W), and the molybdenum (Mo) in the low reflective part is 2.5 at% or more based on a total number of atoms of the tantalum (Ta) and equal to or less than the content ratio of the tantalum (Ta).

10. The reflective photomask according to any one of claims 7 to 9, wherein the low reflective part contains at least one of a material containing tin (Sn) and oxygen (O) and a material containing indium (In) and oxygen (O) as the high extinction coefficient material.

**Patentansprüche**

1. Reflektierender Fotomaskenrohling (10) zur Herstellung einer reflektierenden Fotomaske (20) zur Musterübertragung unter Verwendung von extrem-ultraviolettem Licht als Lichtquelle, wobei der reflektierende Fotomaskenrohling umfasst:

ein Substrat (1);
einen auf dem Substrat (1) ausgebildeten reflektierenden Teil (5), der eingerichtet ist, einfallendes Licht zu reflektieren; und
einen auf dem reflektierenden Teil (5) ausgebildeten schwach reflektierenden Teil (4), der eingerichtet ist, einfallendes Licht zu absorbieren, wobei
der reflektierende Teil (5) einen mehrschichtigen reflektierenden Film (2) und eine Deckschicht (3) einschließt,
der schwach reflektierende Teil (4) ein Material mit hohem Extinktionskoeffizienten, welches ein Material mit einem Extinktionskoeffizienten für EUV-Licht größer als 0,041 ist, Tantal (Ta) und mindestens eines aus einer Materialgruppe, die aus Titan (Ti), Niob (Nb), Wolfram (W) und Molybdän (Mo) besteht, enthält und das Material mit hohem Extinktionskoeffizienten in einem Anteil von mehr als 50 At-% enthält,

ein Gehaltsanteil des mindestens einen aus der Materialgruppe, bestehend aus Titan (Ti), Niob (Nb), Wolfram (W) und Molybdän (Mo) in dem schwach reflektierenden Teil (4) gleich oder niedriger als ein Gehaltsanteil des Tantals (Ta) ist,

die Gesamtfilmdicke des schwach reflektierenden Teils 45 nm oder weniger beträgt und

ein OD (optische Dichte)-Wert des schwach reflektierenden Teils (4) 1,0 oder mehr beträgt.

2. Reflektierender Fotomaskenrohling gemäß Anspruch 1, in dem der Gehaltsanteil des mindestens einen aus der Materialgruppe, bestehend aus Titan (Ti), Niob (Nb), Wolfram (W) und Molybdän (Mo), in dem schwach reflektierenden Teil 2,5 At-% oder mehr, bezogen auf die Gesamtzahl der Atome des Tantals (Ta), beträgt.

3. Reflektierender Fotomaskenrohling gemäß Anspruch 1, in dem der Gehaltsanteil des mindestens einen aus der Materialgruppe, bestehend aus Titan (Ti), Niob (Nb), Wolfram (W) und Molybdän (Mo), in dem schwach reflektierenden Teil 5 At-% oder mehr, bezogen auf die Gesamtzahl der Atome des Tantals (Ta), beträgt.

4. Reflektierender Fotomaskenrohling gemäß Anspruch 1, in dem ein Gehaltsanteil des Titans (Ti), Niobs (Nb), Wolframs (W) und Molybdäns (Mo) in dem schwach reflektierenden Teil 2,5 At-% oder mehr, bezogen auf die Gesamtzahl der Atome des Tantals (Ta), und gleich oder niedriger als der Gehaltsanteil des Tantals (Ta) ist.

5. Reflektierender Fotomaskenrohling gemäß mindestens einem der Ansprüche 2 bis 4, in dem der schwach reflektierende Teil mindestens eines aus einem Material, das Zinn (Sn) und Sauerstoff (O) enthält, und einem Material, das Indium (In) und Sauerstoff (O) enthält, als das Material mit hohem Extinktionskoeffizienten enthält.

6. Reflektierende Fotomaske (20) zur Musterübertragung unter Verwendung von extrem-ultraviolettem Licht als Lichtquelle, wobei die reflektierende Fotomaske (20) umfasst:

ein Substrat (1);

einen auf dem Substrat (1) ausgebildeten reflektierenden Teil (5), der eingerichtet ist, einfallendes Licht zu reflektieren; und

einen auf dem reflektierenden Teil (5) ausgebildeten schwach reflektierenden Teil (4), der eingerichtet ist, einfallendes Licht zu absorbieren, wobei

der reflektierende Teil (5) einen mehrschichtigen reflektierenden Film (2) und eine Deckschicht (3) einschließt,

der schwach reflektierende Teil (4) ein Material mit hohem Extinktionskoeffizienten, welches ein Material mit einem Extinktionskoeffizienten für EUV-Licht größer als 0,041 ist, Tantal (Ta) und mindestens eines aus einer Materialgruppe, bestehend aus Titan (Ti), Niob (Nb), Wolfram (W) und Molybdän (Mo), enthält und das Material mit hohem Extinktionskoeffizienten in einem Anteil von mehr als 50 At-% enthält,

ein Gehaltsanteil des mindestens einen aus der Materialgruppe, bestehend aus Titan (Ti), Niob (Nb), Wolfram (W) und Molybdän (Mo) in dem schwach reflektierenden Teil (4) gleich oder niedriger als ein Gehaltsanteil des Tantals (Ta) ist,

die Gesamtfilmdicke des schwach reflektierenden Teils 45 nm oder weniger beträgt und

ein OD (optische Dichte)-Wert des schwach reflektierenden Teils (4) 1,0 oder mehr beträgt.

7. Reflektierende Fotomaske gemäß Anspruch 6, in der der Gehaltsanteil des mindestens einen aus der Materialgruppe, bestehend aus Titan (Ti), Niob (Nb), Wolfram (W) und Molybdän (Mo), in dem schwach reflektierenden Teil 2,5 At-% oder mehr, bezogen auf die Gesamtzahl der Atome des Tantals (Ta), beträgt.

8. Reflektierende Fotomaske gemäß Anspruch 6, in der der Gehaltsanteil des mindestens einen aus der Materialgruppe, bestehend aus Titan (Ti), Niob (Nb), Wolfram (W) und Molybdän (Mo), in dem schwach reflektierenden Teil 5 At-% oder mehr, bezogen auf die Gesamtzahl der Atome des Tantals (Ta), beträgt.

9. Reflektierende Fotomaske gemäß Anspruch 6, in der ein Gehaltsanteil des Titans (Ti), Niobs (Nb), Wolframs (W) und Molybdäns (Mo) in dem schwach reflektierenden Teil 2,5 At-% oder mehr, bezogen auf die Gesamtzahl der Atome des Tantals (Ta), und gleich oder niedriger als der Gehaltsanteil des Tantals (Ta) ist.

10. Reflektierende Fotomaske gemäß mindestens einem der Ansprüche 7 bis 9, in der der schwach reflektierende Teil mindestens eines aus einem Material, das Zinn (Sn) und Sauerstoff (O) enthält, und einem Material, das Indium (In) und Sauerstoff (O) enthält, als das Material mit hohem Extinktionskoeffizienten enthält.

**Revendications**

1.  Ébauche de photomasque réfléchissant (10) destinée à la fabrication d'un photomasque réfléchissant (20) pour le transfert de motifs à l'aide d'une lumière ultraviolette extrême comme source lumineuse, l'ébauche de photomasque réfléchissant comprenant :

    un substrat (1) ;
    une partie réfléchissante (5) formée sur le substrat (1) et configurée pour réfléchir une lumière incidente ; et une partie faiblement réfléchissante (4) formée sur la partie réfléchissante (5) et configurée pour absorber une lumière incidente, dans lequel
    la partie réfléchissante (5) comprend un film réfléchissant multicouche (2) et une couche de recouvrement (3),
    la partie faiblement réfléchissante (4) contient un matériau à coefficient d'extinction élevé, qui est un matériau présentant un coefficient d'extinction vis-à-vis de la lumière EUV supérieur à 0,041, du tantale (Ta), et au moins un élément d'un groupe de matériaux comprenant le titane (Ti), le niobium (Nb), le tungstène (W) et le molybdène (Mo), et contient le matériau à coefficient d'extinction élevé dans une proportion supérieure à 50 % en atomes,
    le rapport de teneur de l'au moins un élément du groupe de matériaux constitué du titane (Ti), du niobium (Nb), le tungstène (W) et le molybdène (Mo) dans la partie à faible réflexion (4) est égal ou inférieur au rapport de teneur du tantale (Ta),
    l'épaisseur totale du film de la partie à faible réflexion (4) est de 45 nm ou moins, et
    la valeur OD (densité optique) de la partie à faible réflexion (4) est de 1,0 ou plus.

2.  L'ébauche de photomasque réfléchissant selon la revendication 1, dans laquelle le rapport de teneur d'au moins un élément du groupe de matériaux constitué du titane (Ti), du niobium (Nb), du tungstène (W) et du molybdène (Mo) dans la partie à faible réflectivité est de 2,5 % en atomes ou plus par rapport au nombre total d'atomes de tantale (Ta).

3.  L'ébauche de photomasque réfléchissant selon la revendication 1, dans laquelle le rapport de teneur d'au moins un élément du groupe de matériaux constitué du titane (Ti), du niobium (Nb), du tungstène (W) et du molybdène (Mo) dans la partie à faible réflectivité est de 5 % en atomes ou plus par rapport au nombre total d'atomes de tantale (Ta).

4.  L'ébauche de photomasque réfléchissant selon la revendication 1, dans laquelle le rapport de teneur du titane (Ti), du niobium (Nb), du tungstène (W) et du molybdène (Mo) dans la partie à faible réflectivité est de 2,5 % en atomes ou plus par rapport au nombre total d'atomes de tantale (Ta) et est égal ou inférieur au rapport de teneur du tantale (Ta).

5.  L'ébauche de photomasque réfléchissant selon l'une quelconque des revendications 2 à 4, dans laquelle la partie à faible réflectivité contient au moins un matériau contenant de l'étain (Sn) et de l'oxygène (O) et un matériau contenant de l'indium (In) et de l'oxygène (O) en tant que matériau à coefficient d'extinction élevé.

6.  Photomasque réfléchissant (20) destiné au transfert de motifs utilisant une lumière ultraviolette extrême comme source lumineuse, le photomasque réfléchissant (20) comprenant :

    un substrat (1) ;
    une partie réfléchissante (5) formée sur le substrat (1) et configurée pour réfléchir une lumière incidente ; et une partie à faible réflectivité (4) formée sur la partie réfléchissante (5) et configurée pour absorber une lumière incidente, dans lequel
    la partie réfléchissante (5) comprend un film réfléchissant multicouche (2) et une couche de recouvrement (3),
    la partie faiblement réfléchissante (4) contient un matériau à coefficient d'extinction élevé, qui est un matériau présentant un coefficient d'extinction vis-à-vis de la lumière EUV supérieur à 0,041, du tantale (Ta), et au moins un élément d'un groupe de matériaux constitué du titane (Ti), le niobium (Nb), le tungstène (W) et le molybdène (Mo), et contient le matériau à coefficient d'extinction élevé dans une proportion supérieure à 50 % en atomes,
    le rapport de teneur de l'au moins un élément du groupe de matériaux constitué du titane (Ti), du niobium (Nb), le tungstène (W) et le molybdène (Mo) dans la partie à faible réflexion est égal ou inférieur au rapport de teneur du tantale (Ta),
    l'épaisseur totale du film de la partie à faible réflexion (4) est de 45 nm ou moins, et
    la valeur OD (densité optique) de la partie à faible réflexion (4) est de 1,0 ou plus.

7.  Le photomasque réfléchissant selon la revendication 6, dans lequel le rapport de teneur d'au moins un élément du groupe de matériaux constitué du titane (Ti), du niobium (Nb), du tungstène (W) et du molybdène (Mo) dans la partie à faible réflectivité est de 2,5 % en atomes ou plus par rapport au nombre total d'atomes de tantale (Ta).

8. Le photomasque réfléchissant selon la revendication 6, dans lequel le rapport de teneur d'au moins un élément du groupe de matériaux constitué du titane (Ti), du niobium (Nb), du tungstène (W) et du molybdène (Mo) dans la partie à faible réflectivité est de 5 % en atomes ou plus par rapport au nombre total d'atomes de tantale (Ta).

9. Masque photographique réfléchissant selon la revendication 6, dans lequel le rapport de teneur du titane (Ti), du niobium (Nb), du tungstène (W) et du molybdène (Mo) dans la partie à faible réflectivité est de 2,5 % en atomes ou plus par rapport au nombre total d'atomes de tantale (Ta) et est égal ou inférieur au rapport de teneur du tantale (Ta).

10. Le photomasque réfléchissant selon l'une quelconque des revendications 7 à 9, dans lequel la partie à faible réflectivité contient au moins l'un parmi un matériau contenant de l'étain (Sn) et de l'oxygène (O) et un matériau contenant de l'indium (In) et de l'oxygène (O) en tant que matériau à coefficient d'extinction élevé.

# FIG. 1

# FIG. 2

FIG. 3

# FIG. 4

# FIG. 5

## FIG. 6

## FIG. 7

FIG. 8

FIG. 9

# FIG. 10

14a

x-DIRECTION LS PATTERN

y-DIRECTION LS PATTERN

14

16

64nm

128nm

EUV IRRADIATION DIRECTION
(6°)

EUV IRRADIATION DIRECTION
(6°)

# FIG. 11

242

241

24

13

12

16

11

15

101

# FIG. 12

**EP 4 350 435 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2020137928 A1
- JP 2011176162 A
- JP 2007273678 A
- JP 2011530823 A